## Europäisches Patentamt

## European Patent Office

## Office européen des brevets

(19)

(11) Veröffentlichungsnummer: **0 057 477**
A2

(12) **EUROPÄISCHE PATENTANMELDUNG**

(21) Anmeldenummer: 82200029.5

(22) Anmeldetag: 13.01.82

(51) Int. Cl.³: **G 05 B 11/10,** G 01 R 17/06

(30) Priorität: 30.01.81 CH 682/81

(43) Veröffentlichungstag der Anmeldung: **11.08.82**
**Patentblatt 82/32**

(84) Benannte Vertragsstaaten: **CH DE FR GB IT LI**

(71) Anmelder: **Werkzeugmaschinenfabrik Oerlikon-Bührle AG, Birchstrasse 155, CH-8050 Zürich (CH)**

(72) Erfinder: **Bohler, Pierre, Dr., Burstwiesenstrasse 50, CH-8055 Zürich (CH)**
Erfinder: **Bertholet, Marc, Baumackerstrasse 59, CH-8050 Zürich (CH)**

(54) **Regelkreis mit Abgleichvorrichtung.**

(57) Bei bekannten Regelkreisen bereitet die Kompensation einer Störgrösse (Z) oftmals Schwierigkeiten. Um die Störgrösse (Z) kompensieren zu können, wird ein zweiter Regelkreis vorgeschlagen, bei dem der Regler (G1) des ersten Regelkreises die Regelstrecke darstellt und ein zweiter Regler (G2) zum Regeln der Ausgangsgrösse des ersten Reglers (G1) angeordnet ist, wobei die zu kompensierende Störgrösse (Z) in einer digitalen Speichereinrichtung des zweiten Regelkreises gespeichert werden kann.

## Regelkreis mit Abgleichvorrichtung

Die Erfindung betrifft einen Regelkreis mit einer Abgleichvorrichtung, enthaltend:

- eine Regelstrecke (G), mit einer Ausgangsgrösse (Yp)

- einen Regler (G1) zum Regeln der Ausgangsgrösse der Regelstrecke (G),
- einen Messwertumformer (M) zum Umformen der Ausgangsgrösse (Yp), insbesondere der Drehzahl, in einen proportionalen elektrischen Istwert (Y),
- einen Summierer (A1) zum Vergleichen des elektrischen Istwertes (Y) mit einem elektrischen Sollwert (X) und
- eine Kompensationsvorrichtung zum Abgleichen einer Störgrösse (Z) des Messwertumformers (M), des Summierers (A) und des Reglers (G1).

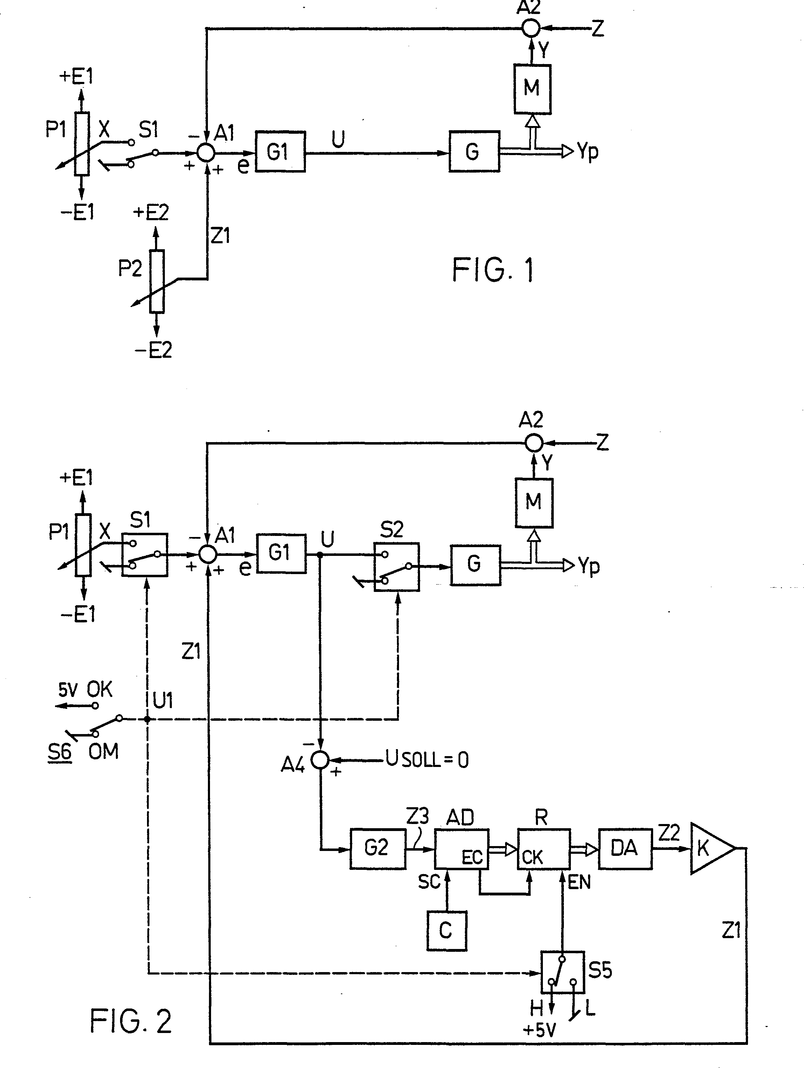

Bei einem bekannten Regelkreis mit Abgleichvorrichtung dieser Art wird die Nullabweichung mit Hilfe eines einstellbaren Potentiometers (P2) kompensiert, wie aus Fig. 1 der beigefügten Zeichnung ersichtlich ist. Diese bekannte Abgleichvorrichtung hat folgende Nachteile:

a) Der Abgleich ist zeitraubend.
b) Die kinematische Grösse Yp, z.B. die Drehzahl bzw. der Stillstand eines Elektromotors muss beobachtbar sein.
c) Die Genauigkeit ist ungenügend.
d) Ein genaues Abgleichen ist bei Regelkreisen, die einen Regler mit Integralverhalten aufweisen, schwierig, besonders, wenn eine Regelstrecke mit Reibung vorhanden ist.
e) Falls die Nullabweichung sich ändert, muss der Abgleich stets wiederholt werden.

- 2 -

Die Aufgabe, welche mit der vorliegenden Erfindung gelöst werden soll, besteht in der Schaffung einer Vorrichtung, mit der sich der Abgleich leicht und genau
durchführen lässt, ohne dass es notwendig ist, ein
Potentiometer genau von Hand einzustellen. Es genügt,
zum Messen der Nullabweichung einen Schalter zu betätigen und zum Kompensieren der Nullabweichung diesen Schalter wieder in seine Ausgangslage zu bewegen.

Die erfindungsgemässe Abgleichvorrichtung an einem
Regelkreis ist dadurch gekennzeichnet, dass die Kompensationsvorrichtung als ein zusätzlicher Regelkreis
ausgebildet ist, enthaltend:
- einen Regler (G1) als Regelstrecke,
- einen zweiten Regler (G2) zum Regeln der Ausgangsgrösse des Reglers (G1),
- eine digitale Speichereinrichtung (R) mit einem
  Analog-Digital-Wandler (AD) am Eingang und mit
  einem Digital-Analog-Wandler (DA) am Ausgang, sowie
- einen Verstärker (K),
um die Störgrösse (Z) des ersten Regelkreises
durch eine Kompensationsspannung (Z1) zu kompensieren.

Ausführungsbeispiele der erfindungsgemässen Abgleichvorrichtung an einem Regelkreis sind im folgenden
anhand der beigefügten Zeichnung ausführlich beschrieben. Es zeigt:

Fig. 1  ein Blockschema eines Regelkreises mit einer
        an sich bekannten Kompensationsvorrichtung,
Fig. 2  ein Blockschema eines Regelkreises mit der
        erfindungsgemässen Kompensationsvorrichtung,
        gemäss einem ersten Ausführungsbeispiel,

Fig. 3   ein Blockschema eines Regelkreises mit der erfindungsgemässen Kompensationsvorrichtung, gemäss einem zweiten Ausführungsbeispiel,

Fig. 4   ein Zeitdiagramm mit dem Spannungsverlauf der Steuerlogik,

Fig.5-7 ein Proportionalregler für den ersten Regelkreis mit den zugehörigen Reglern für den zusätzlichen Regelkreis,

Fig.8-10 ein Integralregler für den ersten Regelkreis mit den zugehörigen Reglern für den zusätzlichen Regelkreis, und

Fig.11-13 ein Proportional-Integralregler für den ersten Regelkreis mit den zugehörigen Reglern für den zusätzlichen Regelkreis.

Gemäss Fig. 1 weist der Regelkreis mit der bekannten Abgleichvorrichtung eine Regelstrecke G auf. Diese Regelstrecke G besteht z.B. aus einem Elektromotor oder einem Hydromotor. Die Regelstrecke G kann aber auch aus einer kreisstabilisierten, drehbaren Waffenanlage bestehen. Die Regelstrecke G liefert eine Ausgangsgrösse, die kinematische Grösse $Y_p$. Bei einem Motor ist diese kinematische Grösse $Y_p$ gleich der Drehzahl des Motors. Die kinematische Grösse $Y_p$ wird mit Hilfe eines Messwertumformers M, z.B. eines Kreiselgerätes, in eine proportionale elektrische Grösse Y umgewandelt. Diese elektrische Grösse Y wird mit einer zweiten elektrischen Grösse X dem Sollwert in einem Summierer Al verglichen. Zur Erzeugung des Sollwertes X dient ein Potentiometer P1, das an eine positive Spannungsquelle +El und an eine negative Spannungsquelle -El angeschlossen ist. Die Abweichung zwischen Istwert Y und Sollwert X wird vom Summierer Al einem Regler Gl zugeführt. Als Regler Gl kann vorzugsweise ein

- 4 -

Regler mit Integralverhalten verwendet werden. Der Regler G1 liefert die Eingangsspannung U für die Regelstrecke G. Handelt es sich bei der Regelstrecke G - wie erwähnt - z.B. um einen Elektromotor, so wird die Ist-Drehzahl Yp mit Hilfe eines Tachogenerators oder allgemein mit Hilfe eines Drehzahlmessers gemessen und mit Hilfe des Messwertumformers M in ein der Drehzahl proportionales Mess-Signal Y umgewandelt. Im Summierer A1 wird der Istwert Y der Drehzahl mit dem Sollwert X der Drehzahl verglichen. Falls Sollwert X und Istwert Y voneinander abweichen, erhält der Regler G1 ein der Abweichung entsprechendes Signal. Mit Hilfe des Reglers G1 wird die Drehzahl des Motors solange verstellt, bis die Abweichung verschwindet, d.h. bis Sollwert X und Istwert Y miteinander übereinstimmen.

In der Praxis hat es sich nun gezeigt, dass der Messwertumformer M und der Summierer A1 sich nicht ideal verhalten. Insbesondere wird z.B. bei stillstehendem Motor der Messwertumformer M nicht - wie erwähnt - ein Mess-Signal Y = O erzeugen. Dies hat dann zur Folge, dass der Motor nicht still stehen bleibt, auch wenn der Sollwert X = O ist. Zur Vermeidung dieser Schwierigkeit ist es üblich, ein Potentiometer P2 anzuordnen, das ebenfalls an den Summierer A1 angeschlossen ist. Zum besseren Verständnis wird angenommen, dass die in der Zeichnung dargestellten Instrumente sich ideal verhalten, d.h., es wird angenommen, dass sie fehlerfrei arbeiten. Man stellt sich einen idealen Regelkreis vor. In Fig. 1 wird daher statt der erwähnten Fehlergrössen eine Störgrösse Z eingezeichnet, welche sämtliche Fehlergrössen der einzelnen Instrumente umfasst. Diese Störgrösse Z wird am Ausgang des Messwertumformers M in den idealen Regelkreis eingeleitet. Zur Kompensation der Störgrösse Z, die im wesentlichen dem Fehler des Messwertumformers M und den übrigen Fehlern im Regelkreis entspricht, wird dem Summierer A1 mit Hilfe eines zweiten Potentiometers P2 ein Kompensationssignal Z1 zugeführt. Stimmt dieses Kompensationssignal Z1 mit dem Störsignal Z überein, dann ist eine vollständige Kompensation der Offsetfehler erreicht, und bei Sollwert X = O ist der Istwert Yp auch Null.

Die Einstellung des Potentiometers P2 kann folgendermassen durchgeführt werden.

Der Sollwert X wird mit Hilfe eines Schalters S1 ausgeschaltet. Somit wird dem Summierer A1 ein Sollwert X = O zugeführt. Es wäre daher zu erwarten, dass der Istwert Yp ebenfalls verschwindet. In den Summierer A1 gelangt jedoch die Störgrösse Z, und daher wird der Istwert Y von Null verschieden sein.

Bei einem Elektromotor lässt sich der Stillstand durch Beobachten erkennen, sofern die Drehzahl nicht sehr klein ist. Das Potentiometer P2, das an eine positive Spannungsquelle +E2 und an eine negative Spannungsquelle -E2 angeschlossen ist, wird so eingestellt, dass die Störgrösse Z durch das Kompensationssignal Z1 völlig kompensiert ist. Bei einem Motor wird das Potentiometer P2 so eingestellt, dass der Motor still steht.

Es hat sich nun gezeigt, dass diese Einstellung schwierig ist und zwar aus folgenden Gründen:

1. Die Einstellung des Potentiometers ist zeitraubend und erfordert Geduld. Z.B. ist es schwierig zu erkennen, ob ein Motor still steht, man denke nur an den Stundenzeiger einer Uhr, der nur scheinbar still steht.

2. Man muss die Möglichkeit haben, den Istwert Y, d.h. die kinematische Grösse beobachten zu können. Dies ist nicht immer der Fall. Z.B. eine Kanone müsste auf ein stillstehendes Ziel gerichtet werden können, um festzustellen, ob sie nach einer gewissen Zeit immer noch auf dieses Ziel gerichtet ist.

3. Bei Reglern mit Integralverhalten ist ein genaues Abgleichen besonders schwierig, da Einstellungsfehler fortlaufend integriert werden.

4. Wenn die Regelstrecke G, z.B. der erwähnte Elektromotor Reibung aufweist, wird ein präziser Abgleich zusätzlich erschwert, da der Motor anfänglich still stehen kann und später doch abwandern kann, sobald die Eingangsspannung U durch Integration die Reibungsschwelle durchbricht.

5. In vielen Fällen ist die Störgrösse Z variabel, dies bedeutet, dass das Potentiometer P2 laufend nachgestellt werden muss.

6. In gewissen Fällen ist die erforderliche Genauigkeit nicht erreichbar, da - wie erwähnt - z.B. der Stillstand eines Uhrzeigers nicht leicht erkennbar ist.

Alle Schwierigkeiten sollen durch die erfindungsgemässe Abgleichvorrichtung vermieden werden.

In Fig. 2 ist ein ähnlicher Regelkreis wie in Fig. 1
dargestellt. Dieser Regelkreis weist ebenfalls eine
Regelstrecke G, einen Messwertumformer M, einen
Summierer Al und einen Regler Gl auf. Der Istwert Y
wird im Summierer Al mit dem Sollwert X verglichen.
Die Fehler im Regelkreis sind ebenfalls durch eine
Störgrösse Z angedeutet.

Das in Fig. 1 dargestellte Potentiometer P2 ist gemäss Fig. 2 durch einen zweiten Regelkreis ersetzt.
Dieser zusätzliche Regelkreis hat wie Potentiometer
P2 aus Fig. 1 die Aufgabe, die Störgrösse Z zu kompensieren. Der zusätzliche Regelkreis weist einen
Regler G2 auf, der an den Ausgang des Reglers Gl
angeschlossen ist. An den Regler G2 sind hintereinander ein Analog-Digital-Wandler AD, ein digitaler Speicher R, ein Digital-Analog-Wandler DA
und ein Verstärker K angeordnet. Der Ausgang des Verstärkers K ist an einen positiven Eingang des Summierers Al angeschlossen.

Genau wie in Fig. 1 weist der Summierer Al, gemäss
Fig. 2, einen negativen und zwei positive Eingänge
sowie einen Ausgang auf. Durch den negativen Eingang werden die Störgrösse Z und der Istwert Y zugeführt. Durch den ersten positiven Eingang wird eine
Kompensationsgrösse Zl zugeführt, die der Störgrösse
Z entspricht. Schliesslich wird dem Summierer Al
durch den zweiten positiven Eingang der Sollwert X
zugeführt. Am Ausgang erscheint dann nur noch die
Abweichung e zwischen Sollwert X und Istwert Y, sofern sich Störgrösse Z und Kompensationsgrösse Z1 tatsächlich kompensieren.

Ein Impulsgenerator C ist an einem Eingang SC (start conversion) des Wandlers AD angeschlossen und dient zum periodischen Starten des Wandlers.AD. Der Ausgang EC (end of conversion) des Wandlers AD ist am Eingang CK (clock) des Schiebehalteregisters oder digitalen Speichers R angeschlossen. Die am Ausgang des Wandlers AD anstehende digitale Information wird dem ersten Eingang des Schiebehalteregisters R zugeführt, sobald am zweiten Eingang CK des Registers R ein Impuls eintrifft. Das Schiebehalteregister R weist noch einen dritten Eingang EN auf. Wenn an diesem dritten Eingang ein Impuls eintritt, wird die im Register R eingelesene Information an den Wandler DA weitergegeben.

Gemäss Fig. 2 weist der Regelkreis mit der Abgleichvorrichtung folgende Schalter auf:

a) Ein erster Schalter S1 ermöglicht es wahlweise, den Summierer A1 entweder mit dem Potentiometer P1 oder mit einem Nullpotential zu verbinden, um dem Summierer A1 entweder den Sollwert X oder die Spannung X = O zuzuführen.

b) Ein zweiter Schalter S2 ermöglicht es, wahlweise die Regelstrecke G, z.B. einen Elektromotor, entweder mit dem Regler G1 oder mit einem Nullpotential zu verbinden, um der Regelstrecke G entweder die Steuerspannung U oder die Spannung U = O zuzuführen.

c) Ein weiterer Schalter S5 ermöglicht es wahlweise, dem Schiebehalteregister R am Eingang EN eine Spannung H (logisch High) von 5 Volt oder eine Spannung L (logisch Low) von O Volt zuzuführen.

d) Ein letzter Schalter S6 ist mechanisch, z.B. von Hand, entweder in eine erste Stellung OM (Messen) oder in eine zweite Stellung OK (Kompensieren) umschaltbar. Dieser Schalter S6 ist elektrisch mit den anderen drei Schaltern S1, S2 und S5 verbunden. Wird der Schalter S6 auf OM (Messen) geschaltet, dann sind die beiden Schalter S1 und S2 in der Stellung gemäss Fig. 2, d.h. der Summierer A1 und die Regelstrecke G sind an das Nullpotential angeschlossen. Der Schalter S5 ist gemäss Fig. 2 an die Spannung H von 5 Volt angeschlossen, wodurch das Schiebehalteregister gesperrt ist.

Die Wirkungsweise des Regelkreises mit Abgleichvorrichtung gemäss Fig. 2 ist wie folgt.

Zuerst wird mit dem zusätzlichen Regelkreis die Störgrösse Z gemessen. Zu diesem Zweck werden mit Hilfe des Schalters S6 die beiden Schalter S1 und S2 geöffnet, d.h. auf Nullpotential umgeschaltet. Der Sollwert X gelangt nicht mehr zum Summierer A1, d.h. am zweiten positiven Eingang des Summie- rers A1 steht der Wert X = O an. Die Steuerstrecke G ist vom Regler G1 getrennt. Somit ist auch der Istwert Yp gleich Null. Somit wird dem Summierer A1 am negativen Eingang ausschliesslich die Störgrösse Z zugeleitet. Der zweite Regelkreis hat nun die Aufgabe, dem Summierer A1 am ersten positiven Eingang eine Kompensationsgrösse Z1 = Z zuzuführen.

Zum besseren Verständnis der Wirkungsweise ist in Fig. 2 ein virtueller Summierer A4 eingezeichnet, an dessen positiven Eingang ein Sollwert $U_{SOLL} = 0$ angelegt ist. Der Ausgang von A4 ist über Regler G2, Wandler AD, Register R, Wandler DA und Verstärker K an den positiven Eingang des Summierers A1 angeschlossen. Der Ausgang des Verstärkers K liefert die Kompensationsgrösse Z1. Am negativen Eingang des Summierers A1 wird die zu messende Störgrösse Z zugeführt. Der Ausgang des Summierers A1 ist mit dem Eingang des Reglers G1 verbunden. Der Regler G1 liefert an seinem Ausgang eine Spannung U, welche den Istwert des zusätzlichen Regelkreises bildet. Der Ausgang des Reglers G1 ist mit dem negativen Eingang des Summierers A4 verbunden. Der Istwert, d.h. die Spannung U wird im Summierer A4 mit dem Sollwert $U_{SOLL} = 0$ verglichen. Der Regler G2 weist stets Integralverhalten auf. Seine Struktur ist derart auf die Struktur des Reglers G1 abgestimmt, dass sich der Istwert U auf den virtuellen Sollwert $U_{SOLL} = 0$ einstellt und zwar unabhängig von der Störgrösse Z. Dadurch hat sich auch die Kompensationsgrösse Z1 auf die Störgrösse Z eingestellt. Falls der zu messenden Störgrösse Z Störungen von höherer Frequenz als die Schwankungen der Störgrösse Z überlagert werden, wird die Struktur des Reglers G2 so ausgebildet, dass nur der Mittelwert der Störgrösse Z gemessen wird und in der Kompensationsgrösse Z1 berücksichtigt wird.

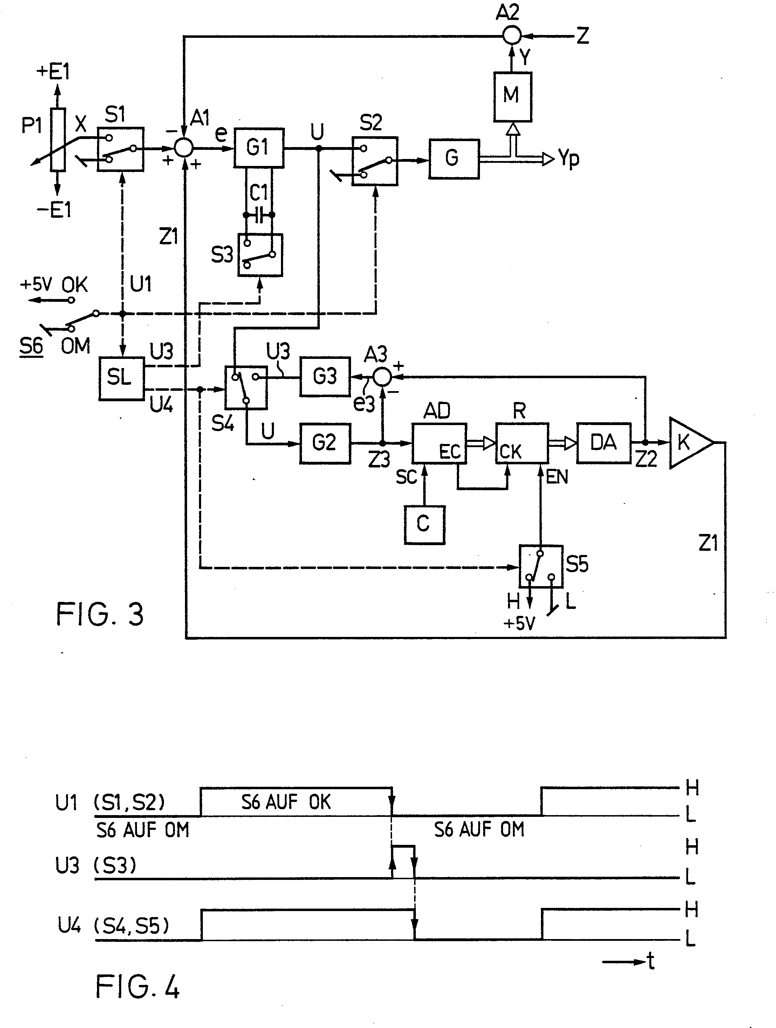

Bei dem Ausführungsbeispiel, gemäss Fig. 3, sind in den Regelkreis mit Abgleichvorrichtung, gemäss Fig. 2, noch folgende zusätzlichen Organe hinzugefügt worden.

Der Regler G1 enthält, falls er als Regler mit Integralverhalten ausgebildet ist, einen Kondensator CI, der nur in Fig. 3 sichtbar ist. An diesen Kondensator CI ist ein Schalter S3 angeschlossen, mit dem der Kondensator CI kurzgeschlossen und somit entladen werden kann.

Ein dritter Regelkreis weist, gemäss Fig. 3, einen dritten Regler G3 auf, dessen Eingang mit dem Ausgang eines weiteren Summierers A3 verbunden ist. Mit dem Summierer A3 wird die Störgrösse Z2 am Ausgang des Wandlers DA mit der Störgrösse Z3 am Ausgang des zweiten Reglers G2 verglichen, und die Abweichung e3 zwischen den beiden Störgrössen Z2 und Z3 wird dem dritten Regler G3 zugeführt. Mit diesem dritten Regelkreis wird erreicht, dass bei einer Messung der Störgrösse Z1 der vorherige Wert der Störgrösse Z1 als Anfangszustand gilt, wodurch eine Verkürzung der Regelzeit für die jeweilige Messung der Störgrösse Z1 erzielt wird, falls die alte und die neue Störgrösse Z1 nicht wesentlich voneinander abweichen.

Ferner ist ein weiterer Schalter S4 vorhanden, mit dem der Regler G2 wahlweise an den ersten Regler G1 oder an den Regler G3 angeschlossen werden kann, um entweder die neue Störgrösse Z1 zu messen oder den Regler G2 auf die vorherige Störgrösse Z2 abzustimmen.

Zur Betätigung der beiden soeben beschriebenen Schalter S3 und S4 ist noch eine Steuerlogik SL vorhanden, deren Eingang mit dem mechanisch betätigbaren Schalter S6, deren erster Ausgang U3 mit dem Schalter S3 und deren zweiter Ausgang U4 mit den Schaltern S4 und S5 verbunden ist.

Das Verhalten dieser Steuerlogik SL ist aus dem Zeitdiagramm Fig. 4 ersichtlich. Solange sich der mechanisch betätigbare Schalter S6 in der gezeigten Stellung OM (Messen) befindet, sind sämtliche Schalter S1 - S5 ebenfalls in der gezeigten Stellung, d.h. zum Messen sind die beiden Schalter S1 und S2 offen und somit an das Nullpotential gelegt. Ebenso ist der Schalter S3 offen, d.h. der Kondensator CI kann aufgeladen werden. Der Schalter S4 verbindet den Regler G1 mit dem Regler G2. Der Schalter S5 ist auf logisch H = 5 Volt, so dass das Register R aufnahmebereit ist.

Wird der Schalter S6 mechanisch auf OK (Kompensieren) umgeschaltet, dann schalten sich sofort die Schalter S1 und S2 und S4 und S5 um, während der Schalter S3 in seiner Stellung, gemäss Fig. 3, verbleibt.

Wird der Schalter S6 mechanisch auf OM (Messen) umgeschaltet, dann werden zuerst die Schalter S1, S2 geöffnet, der Schalter S3 geschlossen und der Kondensator CI entladen. Nach wenigen Millisekunden springt der Schalter S3 in seine Ausgangslage zurück, und die beiden Schalter S4 und S5 gelangen in die in Fig. 3 gezeigte Stellung.

Die Wirkungsweise des zweiten Ausführungsbeispieles, gemäss Fig. 3, entspricht im wesentlichen der Wirkungsweise des ersten Ausführungsbeispieles, gemäss Fig. 2, und muss daher nicht nochmals beschrieben werden. Durch den Schalter S3 kann zu Beginn der Messung der Kondensator CI des Reglers G1 entladen werden, und durch den Schalter S4 kann der Regler G2 dem Wert der Störgrösse Z angepasst werden. Durch beide Massnahmen wird die erforderliche Regelzeit verkürzt.

Wie schon weiter oben angedeutet, müssen die Regler G2 und G3 dem gegebenen Regler G1 angepasst werden. Die Abhängigkeit dieser Regler G1, G2 und G3 voneinander ergibt sich aus folgenden Formeln. Die in diesen Formeln verwendeten Zeichen haben folgende Bedeutung:

N   - "Wortlänge" in Bit der Wandler AD und DA (Analog-Digital-Wandler und Digital-Analog-Wandler),

K   - Verstärkungsfaktor des Verstärkers K,

G1(S)   - sind Reglerübertragungsfunktionen,

G2(S)

G3(S)

S   ist der Laplace-Operator,

Zmin   - erwünschte Auflösung bzw. Genauigkeit der Offsetabgleichvorrichtung

Zmax   - maximal zu erwartende Offsetspannung,

VRef   - Referenzspannung der Wandler AD und DA,

f2   - Bandbreite des Mess-Regelkreises für die Offsetspannung

f3   - Bandbreite des Regelkreises für den Ausgangszustand,

T   - Zeitkonstante

1) $N = \dfrac{\ln\ (Zmax/Zmin)}{\ln 2}$

2) $K = \dfrac{Zmax}{VRef}$

3) $T2 = \dfrac{1}{2\pi\,f2}$    $T3 = \dfrac{1}{2\pi\,f3}$

a) für G1(S) = Kp  gilt bei Proportionalreglern
(Fig. 5-7)

4) $G2(S) = \frac{1}{KKp} \cdot \frac{1}{ST2}$  und G3(S) kkp $\frac{T2}{T3}$

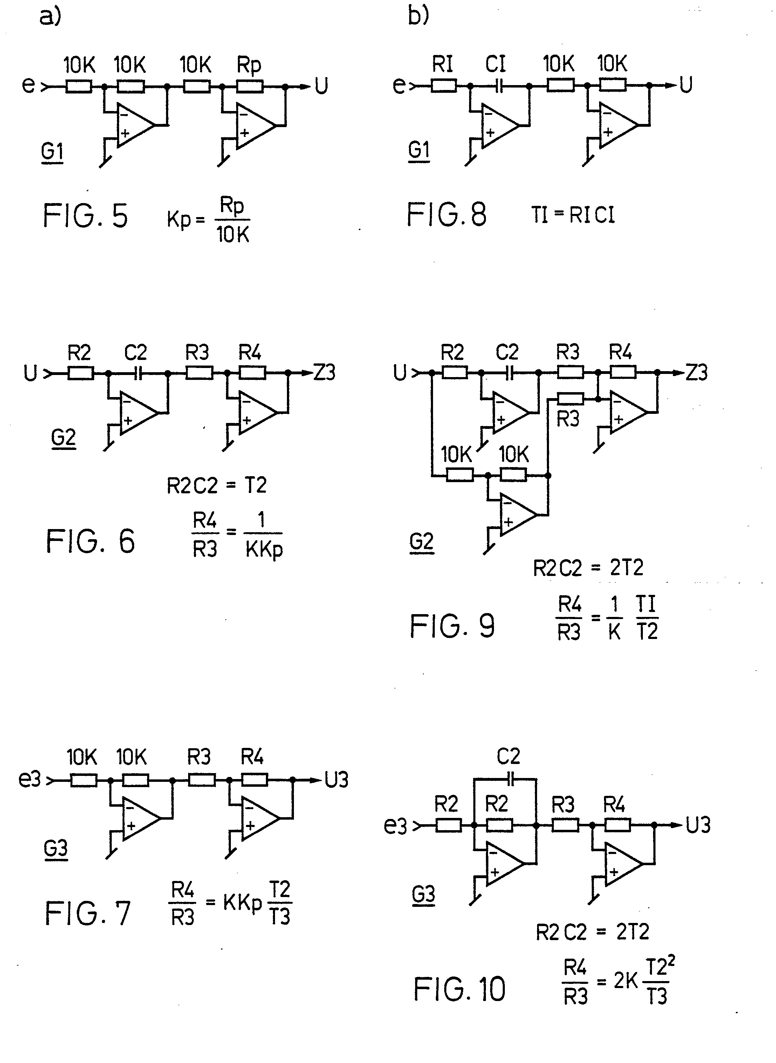

b) für G1  $= \frac{1}{STI}$ gilt bei Integralreglern (Fig.8-10)

5) $G2(S) = \frac{1}{K} \frac{TI}{T2} \cdot \frac{1+2ST2}{2ST2}$  und

$G3(S) = \frac{2K \ T2}{T3} \frac{1}{1+2ST2}$

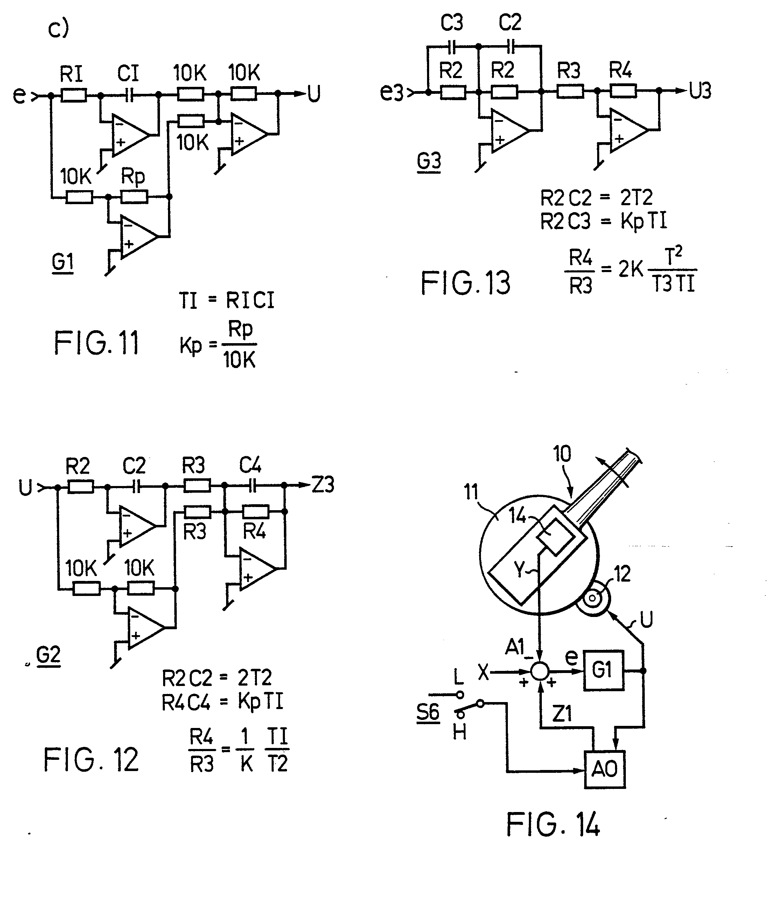

c) für G1(S) = Kp + $\frac{1}{STI}$  gilt bei Proportional-Integralreglern (Fig. 11-13)

6) $G2(S) = \frac{1}{K} \cdot \frac{TI}{T2} \cdot \frac{1+2ST2}{2ST2} \cdot \frac{1}{1+SKpTI}$

$G3(S) = \frac{2K \ T2}{T3TI} \cdot \frac{1+2Kp \ TI}{1+2ST2}$

Diese Zusammenhänge sind durch die Schaltungen in den Figuren 5-13 noch verdeutlicht.

Gemäss Fig. 14 kann der in Fig. 2 und 3 dargestellte Regelkreis mit Abgleichvorrichtung für eine kreiselstabilisierte, drehbare Waffenanlage verwendet werden. Diese Waffenanlage weist eine Kanone 10 auf, die auf einer Plattform 11 drehbar gelagert ist. Zum Drehen der Plattform dient ein Motor 12, der in den Fig. 1-3 als Regelstrecke G bezeichnet ist. Auf der Kanone oder Feuerwaffe 10 ist ein Kreisel 14 befestigt, mit dem die Drehgeschwindigkeit der Plattform 11 gemessen wird. Dieser Kreisel 14 entspricht dem Messwertumformer M gemäss Fig. 1-3. Dieser Kreisel 14 bzw. Messwertumformer M ist an den Summierer A1 angeschlossen. Diesem Summierer A1 wird vom Kreisel 14 der Istwert Y zugeführt. Mit Hilfe eines nicht dargestellten Richtgriffes wird dem Summierer Al der Sollwert X zugeführt, und mit dem automatischen Offset-Abgleich AO wird dem Summierer die Kompensationsgrösse Zl zugeführt. Die Abweichung e zwischen Sollwert X und Istwert Y wird dem Regler Gl zugeführt. Dieser Regler Gl regelt die Drehzahl des Motors 14 und informiert den automatischen Offset-Abgleich AO. Der automatische Offset-Abgleich AO wird durch den zusätzlichen Regelkreis, gemäss Fig. 2 und durch zwei zusätzliche Regelkreise gemäss Fig. 3, gebildet. Die Wirkungsweise des automatischen Offset-Abgleiches AO ist anhand der Fig. 2 und 3 beschrieben.

Patentansprüche:

1. Regelkreis mit Abgleicheinrichtung, enthaltend:
   - eine Regelstrecke (G) mit einer Ausgangsgrösse (Yp),
   - einen Regler (Gl) zum Regeln der Ausgangsgrösse (Yp) der Regelstrecke (G),
   - einen Messwertumformer (M) zum Umformen eines der Ausgangsgrösse (Yp) in einen proportionalen elektrischen Istwert (Y),
   - einen Summierer (Al) zum Vergleichen des elektrischen Istwertes (Y) mit einem elektrischen Sollwert (X) und
   - eine Kompensationsvorrichtung zum Abgleichen einer Störgrösse (Z) des Messwertumformers (M), des Summierers (Al) und des Reglers (Gl),
   dadurch gekennzeichnet, dass
   die Kompensationsvorrichtung als ein zusätzlicher Regelkreis ausgebildet ist, enthaltend
   - den Regler (Gl) als Regelstrecke,
   - einen zweiten Regler (G2) zum Regeln der Ausgangsgrösse (U) des Reglers (Gl) auf Null,
   - eine digitale Speichereinrichtung (R) mit einem Analog-Digital-Wandler (AD) am Eingang und einem Digital-Analog-Wandler (DA) am Ausgang, sowie
   - einen Verstärker (K),
   um die Störgrösse (Z) des ersten Regelkreises durch eine Kompensationsspannung (Zl) zu kompensieren.

2. Regelkreis nach Anspruch 1, dadurch gekennzeichnet, dass die Kompensationsvorrichtung ausser dem erwähnten zusätzlichen Regelkreis noch einen weiteren Regelkreis aufweist, enthaltend
- den Regler (G2) als Regelstrecke,
- einen dritten Regler (G3) zum Regeln der Ausgangsgrösse (Z3) des Reglers (G2) und
- einen Summierer (A3),
um bei einer Messung der Störgrösse (Z1) die vorherige Störgrösse (Z1) berücksichtigen zu können.

3. Regelkreis nach Anspruch 1, dadurch gekennzeichnet, dass die Regelstrecke (G) aus einem Elektromotor besteht, dessen Drehzahl die Ausgangsgrösse (Yp) darstellt.

0057477

FIG. 1

FIG. 2

FIG. 3

FIG. 4

0057477

2/4

a)

10K  10K  10K  Rp

e >———[  ]——[  ]——[  ]——[  ]———> U

G1

FIG. 5    $Kp = \dfrac{Rp}{10K}$

b)

RI  CI  10K  10K

e >———[  ]——||——[  ]——[  ]———> U

G1

FIG. 8    $TI = RI \, CI$

R2  C2  R3  R4

U >———[  ]——||——[  ]——[  ]———> Z3

G2

$R2 \, C2 = T2$

FIG. 6    $\dfrac{R4}{R3} = \dfrac{1}{KKp}$

R2  C2  R3  R4

U >———[  ]——||——[  ]——[  ]———> Z3

R3

10K  10K

G2

$R2 \, C2 = 2T2$

FIG. 9    $\dfrac{R4}{R3} = \dfrac{1}{K} \dfrac{TI}{T2}$

10K  10K  R3  R4

e3 >———[  ]——[  ]——[  ]——[  ]———> U3

G3

FIG. 7    $\dfrac{R4}{R3} = KKp \dfrac{T2}{T3}$

C2

R2  R2  R3  R4

e3 >———[  ]——[  ]——[  ]——[  ]———> U3

G3

$R2 \, C2 = 2T2$

FIG. 10    $\dfrac{R4}{R3} = 2K \dfrac{T2^2}{T3}$

0057477

4|4

c)

$TI = RICI$

FIG. 11 $\quad Kp = \dfrac{Rp}{10K}$

$R2\,C2 = 2T2$
$R4\,C4 = KpTI$

$\dfrac{R4}{R3} = \dfrac{1}{K}\,\dfrac{TI}{T2}$

FIG. 12

$R2\,C2 = 2T2$
$R2\,C3 = KpTI$

FIG. 13 $\quad \dfrac{R4}{R3} = 2K\,\dfrac{T^2}{T3\,TI}$

FIG. 14